# EUROPEAN PATENT APPLICATION

(11) **EP 4 815 708 A1**
(43) Date of publication of application: **30.09.2026**
(21) Application number: 25224759.8
(22) Date of filing: 18.12.2025
(51) Int. Cl.: H10W 20/20, H10P 74/00, H10W 20/40, H10W 80/00, H10W 90/00, H10W 90/20

(54) **CARRIER WAFER DIE STITCHING IN BACK-SIDE INTERCONNECT ARCHITECTURES**

(30) Priority: 27.03.2025 US 202519092809
(71) Applicant: Intel Corporation, Santa Clara, CA 95054 (US)
(72) Inventor: FROST, Denzil, Albuquerque, NM 87114 (US); WALLACE, Charles, Portland, OR 97212 (US)
(74) Representative: HGF

(57) **Abstract**

Devices, integrated circuit structures, systems, and techniques are described herein related to die-to-die stitching interconnects formed in a carrier wafer that is used as a support during backside metallization fabrication. A device layer is between frontside interconnect metallization and backside interconnect metallization such that each of the device layer, the frontside interconnect metallization, and the backside interconnect metallization includes active regions separated by an inactive region. Stitch interconnects are above the inactive regions over the frontside interconnect metallization and extend across the inactive regions to couple the active regions and provide die-to-die interconnection therebetween.

## Description

### BACKGROUND

As the integrated circuit industry continues to produce ever more advanced devices for use in various electronic products such as computers, servers, and portable products inclusive of portable computers, electronic tablets, cellular phones, digital cameras, and the like, current die sizes are limited by the size of a standard lithographic reticle that results in one patterned field on the wafer. With ever increasing computational needs, there is a desire to fabricate dies that include multiple lithographic fields of a wafer. That is, in standard processing, the features of a die are fabricated using a single lithographic field that corresponds to a single lithographic exposure using a single reticle. However, there is an increasing desire to fabricate dies that include multiple (e.g., two or more) adjacent lithographic fields. Such fields may be exposed using different reticles or the same reticle. In either context, there is a desire to interconnect features of such fields.

For example, high performance computing (HPC) chips may be designed to be larger than the lithography reticle limit (e.g., a limit of about 800-830 mm² for 193nm immersion lithography), which requires forming interconnect lines across reticle boundaries (also known as the stitching region). Currently, stitching is accomplished by intentionally overlapping reticle shots of adjacent dice and requires multiple reticles per layer. This added complexity increases cost and lowers throughput since lithography steppers are not designed to simultaneously handle multiple reticles efficiently.

It is with respect to these and other considerations that the present improvements have been needed. Such improvements may become critical as the need to provide larger dies having more complicated features is necessary to support ever more sophisticated electronics systems.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG.1 is a flow diagram illustrating exemplary methods for forming die-to-die interconnects using a carrier wafer;
FIGS. 2, 4, 5, 7, 8, 13, and 14 are cross-sectional side views of example integrated circuit structures as particular fabrication operations of the methods of FIG. 1 are performed;
FIGS. 3, 6, 9, 10, 11, and 12 are plan views of example integrated circuit structures as particular fabrication operations of the methods of FIG. 1 are performed;
FIG. 15 illustrates exemplary systems employing integrated circuit structures with carrier-wafer based die-to-die stitching;
FIG. 16 is a block diagram of a computing device, all arranged in accordance with at least some implementations of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure.

Devices, integrated circuit die structures, apparatuses, systems, and techniques are described herein related to interconnect features that extend over inactive boundary regions between active regions of adjacent dies to interconnect or stitch together the active regions by contacting metallization layers of the active regions.

As discussed, there is an increasing need to fabricate dies that include multiple (e.g., two or more) adjacent lithographic fields. Furthermore, there is an ongoing need to provide dense and efficient interconnects to device layers of an integrated circuit device layer. For example, frontside interconnects (i.e., interconnect metallization over the device layer) and backside interconnects (i.e., interconnect metallization under the device layer) may be deployed in some contexts. The techniques discussed herein provide die-to-die stitching or interconnection by interconnects formed in a carrier wafer used as a support structure during fabrication of the backside interconnects. For example, the frontside interconnects may be formed over an integrated circuit device layer (i.e., a layer including transistor devices) with the underlying substrate wafer used for support. Between active frontside interconnects regions (e.g., typical single die regions) are inactive regions that may include inactive metallization. A carrier wafer is then mounted over the frontside interconnects. Prior to or after mounting, interconnects that span the inactive regions are formed such that these stitch interconnects are to couple adjacent active regions. In some embodiments, the stitch interconnects are formed prior to carrier wafer mounting and, for example, hybrid bonding may be used to connect the active regions. In other embodiments, the stitch interconnects are formed after carrier wafer mounting and through substrate (e.g., through the substrate of the carrier wafer) may be used to connect the active regions.

The techniques discussed herein adapt carrier wafer backside interconnect processing by adding interconnect pattering on the carrier wafer. The patterning electrically stitches the dice together during carrier wafer attach for backside metal formation. This processing provides a variety advantages including avoiding the multiple-reticle difficulties of typical stitching, reduced distances and increased interconnect pitches relative to interconnect bridges, flexibility in interconnect from die edge and/or die center, selective interconnection of any number of dies (e.g., using shot mapping), and fan-in/fan-out capabilities for lower R or lower C connections. Other advantages will be evident based on the following disclosure.

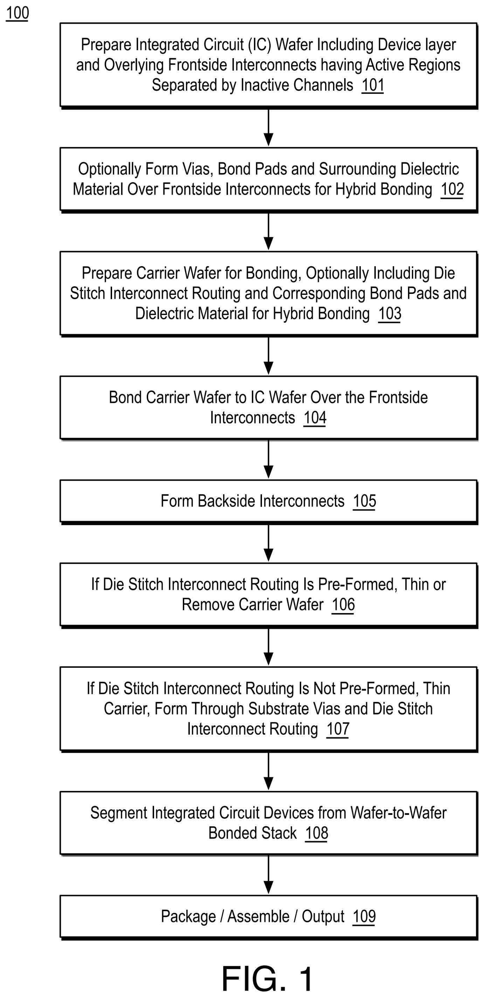

FIG.1 is a flow diagram illustrating exemplary methods 100 for forming die-to-die interconnects using a carrier wafer, arranged in accordance with at least some implementations of the present disclosure. For example, methods 100 may be implemented to fabricate any integrated circuit structures 800, 1300, 1400 or any other integrated circuit structures discussed herein. In the illustrated implementation, methods 100 may include one or more operations as illustrated by operations 101-109. However, embodiments herein may include additional operations, certain operations being omitted, or operations being performed out of the order provided.

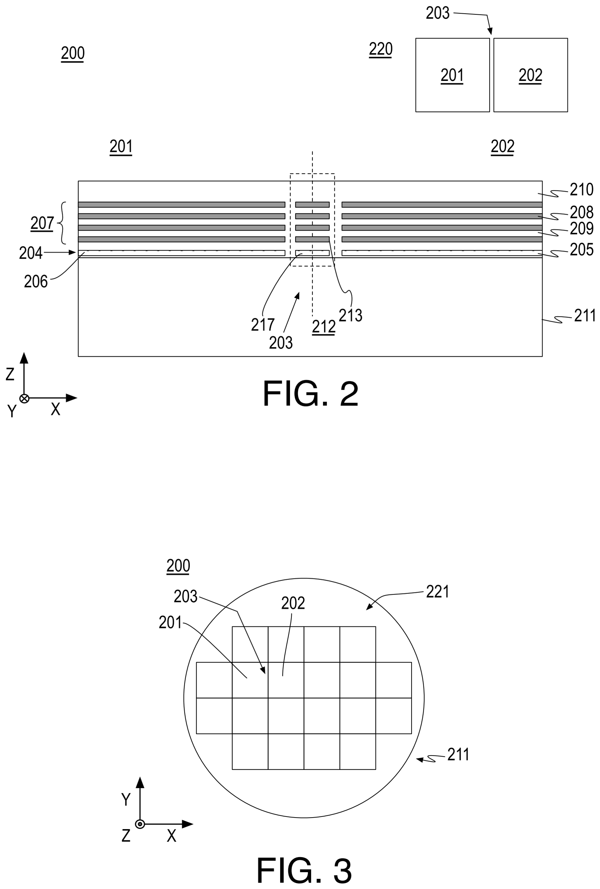

FIGS. 2, 4, 5, 7, 8, 13, and 14 are cross-sectional side views of example integrated circuit structures as particular fabrication operations of methods 100 are performed, arranged in accordance with at least some implementations of the present disclosure. FIGS. 3, 6, 9, 10, 11, and 12 are top-down views of example integrated circuit structures as particular fabrication operations of methods 100 are performed, arranged in accordance with at least some implementations of the present disclosure.

Processing begins at operation 101, where an integrated circuit wafer having any number active regions is prepared. As shown, fabrication of the integrated circuit wafer includes forming a device layer and overlying frontside interconnects. As used herein, the term device layer indicates a layer of any active circuit devices, such as transistors, capacitors, diodes, etc. Frontside interconnects are formed over the device layer and interconnect the devices for signal routing and/or power delivery. In some contexts, the frontside interconnects provide signal routing and subsequently formed backside interconnects provide power delivery.

Furthermore, each of the device layer and the frontside interconnects include any number of active regions separated by inactive regions or boundary regions. As used herein, the term active region indicates a region of any or all layers that provide active devices, routing, etc. that form part of the function of the device. Inactive regions indicate those regions between the active regions that include dummy devices, measurement structures and so on. Such inactive regions may be characterized as scribe lines, dicing streets, or the like. Notably, the structures in the inactive regions are not contacted by functional circuity of the integrated circuit structure.

FIG. 2 illustrates a cross-sectional side view of an example integrated circuit structure 200 with active regions 201, 202 and an inactive region 203 therebetween. As shown, a device layer 204, having active devices 205, 206 such as transistors or other integrated circuit devices, is formed over a substrate 211 (e.g., a substrate wafer). Substrate 211 may include any suitable material or materials and, in some embodiments, substrate 211 includes a material or materials having the same or a similar composition with respect to semiconductor material used in device layer 204. In some embodiments, substrate 211 includes a Group IV material (e.g., silicon). In some embodiments, substrate 211 includes substantially monocrystalline material. Device layer 204 may include any suitable devices such as field effect transistors as is known in the art.

Also as shown, any number of frontside interconnect layers 207 are formed over device layer 204. Frontside interconnect layers 207 include interconnected metallization features 208 embedded in dielectric material 209. Interconnected metallization features 208 may include metal traces such as copper traces that interconnect particular devices of device layer 204 with layers of interconnected metallization features 208 vertically coupled by metal vias (not shown). Frontside interconnect layers 207 may provide signal routing and power delivery for device layer 204.

Notably, each build-up layer of active region 201 may be formed, in part, using a single exposure and corresponding reticle with each build-up layer of active region 202 being formed, in part, using a separate exposure and the corresponding reticle. Each exposure is an exposure step (and optional scan) using a lithography too, as is known in the art. That is, active regions 201, 202 are separate fields corresponding to separate reticle exposures. As discussed, it is desirable, in some contexts, to stitch together active regions 201, 202 for increased functionality of the IC device structure relative to the functionality of active regions 201, 202 alone.

Inactive region 203, which may be substantially centered on a vertical plane 212, is between active regions 201, 202 and may include portions of device layer 204 and frontside interconnect layers 207, however, such components are not active and are not part of the integrated circuit device. Instead, inactive devices 217 and inactive metallization features 213 may be test structures, measurement structures, or the like, and/or they may be deployed to provide topographic consistency. Notably, interconnected metallization features 208 do not provide interconnect routing between active regions 201, 202 such that active regions 201, 202 are eclectically and communicatively isolated from one another in the context of integrated circuit structure 200. FIG. 2 further includes a top-down illustration insert 220 showing the lateral separation and isolation of active regions 201, 202 with inactive region 203 extending therebetween.

FIG. 3 is a plan view of example integrated circuit structure 200 showing a grid 221 of active regions such as active regions 201, 202 separated by inactive region 203, which may extend in, for example, the x-direction and the orthogonal y-direction such that, as discussed, active regions 201, 202 are isolated from one another by inactive region 203. As discussed, each active region of grid 221 may be formed using a single exposure at the particular operation being performed.

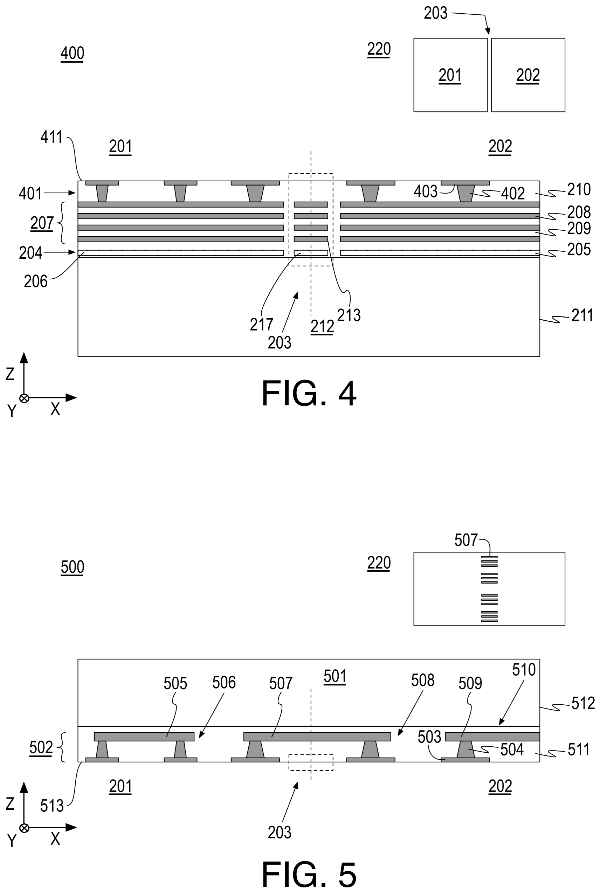

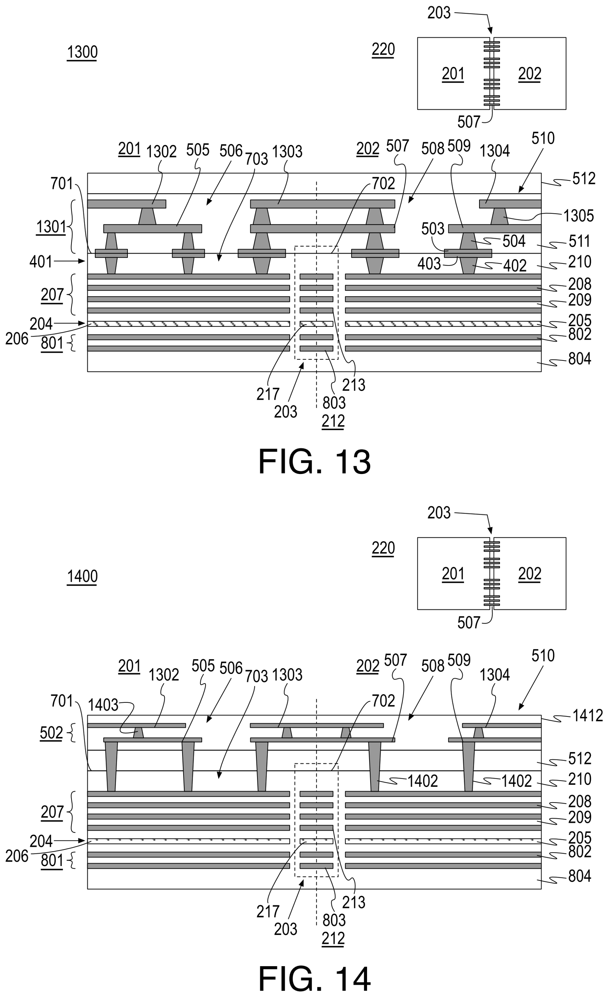

Returning to FIG. 1, processing continues at operation 102, where vias, bond pads, a dielectric layer or material surrounding the bond bads are optionally formed in preparation for hybrid bonding to corresponding structures formed in a carrier wafer. Notably, methods 100 may include forming stitch interconnects in a carrier wafer prior to bonding with the substrate having a device layer and frontside interconnects (see FIGS. 4, 5, 7, 8, and 13) or forming stitch interconnects after mounting to the carrier wafer (see FIG. 14). In the contexts of forming stitch interconnects in the carrier wafer prior to bonding, the substrate having the device layer and frontside interconnects is also pre-processed to receive the stitch interconnects in the carrier wafer. The vias, bond pads, and the dielectric layer surrounding the bond bads may be formed using any suitable technique or techniques such as formation of a dielectric layer, patterning a resist layer over the dielectric layer and etching the dielectric layer, and metal fill. Such techniques may be repeated to form vias and bond pads in a single damascene processing or dual damascene techniques may be used such that the vias and bond pads are deposited contemporaneously.

FIG. 4 illustrates a cross-sectional side view of an example integrated circuit structure 400 similar to integrated circuit structure 200 after formation of an interconnect layer 401 including a dielectric layer 210, metal vias 402, and bond pads 403. In some embodiments, dielectric layer 210 is deposited using any suitable technique or techniques such as chemical vapor deposition (CVD), plasma enhanced chemical vapor deposition (PECVD), metalorganic chemical vapor deposition (MOCVD), or the like. Dielectric layer 210 may be optionally planarized and metal vias 402 and bond pads 403 may be formed using any suitable technique or techniques such as patterning openings in dielectric layer 210 followed by metal fill. Metal vias 402 and bond pads 403 may be any suitable material or materials such as copper. In some embodiments, metal vias 402 and bond pads 403 include a liner material such as titanium nitride, tantalum nitride, or the like.

The materials of dielectric layer 210 and bond pads 403 (or at least the outward facing material of dielectric layer 210 and bond pads 403) may be advantageously selected for subsequent hybrid bonding at surface 411. As discussed, in some embodiments, bond pads 403 are copper. In some embodiments, at least the outer surface of dielectric layer 210 is one of silicon oxide (e.g., dielectric layer 210 includes silicon and oxygen), silicon nitride (e.g., dielectric layer 210 includes silicon and nitrogen), silicon carbon nitride (e.g., dielectric layer 210 includes silicon, carbon, and nitrogen), boron nitride (e.g., dielectric layer 210 includes boron and nitrogen), diamond (e.g., dielectric layer 210 includes carbon), or aluminum nitride (e.g., dielectric layer 210 includes aluminum and nitrogen), with aluminum nitride being particularly advantageous in some contexts.

At surface 411, bond pads 403 provide a particular layout that will be mirrored for hybrid bonding to a carrier wafer having die-to-die stitch interconnects. Bond pads 403 may be provided at any suitable dimensions such as a pitch in the range of about 20 nm to 10 µm. For example, the pitch of bond pads 403 may be limited by alignment capability in wafer-to-wafer bonding between integrated circuit structure 400 and a carrier wafer structure. In some embodiments, the pitch is not less than 20 nm, 40 nm, 50 nm, 80 nm, 160 nm, or 500 nm. Other pitches, such as pitches in the range of about 800 nm to 1 µm (i.e., about 900 nm), pitches in the range of about 800 nm to 3 µm, or pitches up to about 10 µm may be used.

Returning to FIG. 1, processing continues at operation 103, where a carrier wafer is prepared for bonding to the wafer having the device layer. As discussed, in some embodiments, stitch interconnects are fabricated over the carrier wafer prior to bonding with the substrate having the device layer. In such embodiments, the stitch interconnects, vias, bond pads, and the dielectric layer surrounding the bond bads may be formed using any suitable technique or techniques such as formation of a dielectric layer, patterning a resist layer over the dielectric layer, etching the dielectric layer, and metal fill. Such techniques may be repeated to form the stitch interconnects, the vias, and then the bond pads, for example.

In other embodiments, stitch interconnects are formed after mounting to the carrier wafer. In these embodiments, the carrier wafer may be prepared for mounting by application of an optional bonding layer such as a dielectric material including those discussed with respect to dielectric layer 210, such as silicon oxide, silicon nitride, silicon carbon nitride, boron nitride, diamond, aluminum nitride, or others.

FIG. 5 illustrates a cross-sectional side view of an example integrated circuit structure 500 with pre-fabricated interconnects 505, 507, 509 including stitch interconnects 507. As shown, integrated circuit structure 500 defines an overlap region 501 that is to extend over active regions 201, 202 and inactive region 203. Integrated circuit structure 500 includes a carrier substrate 512 (e.g., a substrate wafer) and metallization interconnect layers 502. Carrier substrate 512 may be any suitable material or materials that provide structural support after bonding to another wafer. In some embodiments, carrier substrate 512 includes a material or materials having the same or a similar composition with respect to substrate 211. In some embodiments, carrier substrate 512 includes a Group IV material (e.g., silicon). In some embodiments, carrier substrate 512 includes substantially monocrystalline material. However, other materials may be used. As shown, interconnects 505, 507, 509 are coupled to bond pads 503 by metal vias 504. In the illustrated example, interconnect 505 and corresponding metal vias 504 and bond pads 503 provide an intra-die interconnect 506 such that intra-die interconnect 506 couples to frontside interconnect layers 207 within active region 201. Similarly, interconnect 509 and corresponding metal vias 504 and bond pads 503 provide an intra-die interconnect 510 that couples to frontside interconnect layers 207 within active region 202, with only one via 504/bond pad 503 shown in FIG. 5.

As also shown in FIG. 5, inclusive of insert 220, stitch interconnects 507 and pertinent ones of metal vias 504 and bond pads 503 provide die-to-die interconnect 508 (or a stitch interconnect) that couples active region 201 to active region 202 by extending over or spanning inactive region 203. Although illustrated with respect to die-to-die interconnect 508 extending from near an inner edge of active region 201 to near an inner edge of active region 202, it will be appreciated that die-to-die interconnect 508 may extend into a central region of one or both of active regions 201, 202, or even to an outer edge of one or both of active regions 201, 202.

Interconnects 505, 507, 509, metal vias 504, and bond pads 503 of may be formed using any suitable technique or techniques. In some embodiments, dielectric layer 511 or multiple dielectric layers are using, for example, CVD, PECVD, metalorganic chemical vapor deposition (MOCVD), or the like. Interconnects 505, 507, 509, metal vias 504, and bond pads 503 may be formed using single damascene or dual damascene techniques. Metal vias 504 and bond pads 503 may be any suitable material or materials such as copper. In some embodiments, metal vias 504 and bond pads 503 include a liner material as discussed with respect to metal vias 402 and bond pads 403.

As with integrated circuit structure 400, the materials of dielectric layer 511 and bond pads 503 (or at least the outward facing material of dielectric layer 511 and bond pads 503) may be advantageously selected for subsequent hybrid bonding at surface 513. In some embodiments, bond pads 503 are copper. In some embodiments, at least the outer surface of dielectric layer 511 is one of silicon oxide (e.g., dielectric layer 511 includes silicon and oxygen), silicon nitride (e.g., dielectric layer 511 includes silicon and nitrogen), silicon carbon nitride (e.g., dielectric layer 511 includes silicon, carbon, and nitrogen), boron nitride (e.g., dielectric layer 511 includes boron and nitrogen), diamond (e.g., dielectric layer 511 includes carbon), or aluminum nitride (e.g., dielectric layer 511 includes aluminum and nitrogen), with aluminum nitride being particularly advantageous in some contexts. The materials of dielectric layer 210 and dielectric layer 511 may be the same or they may be different.

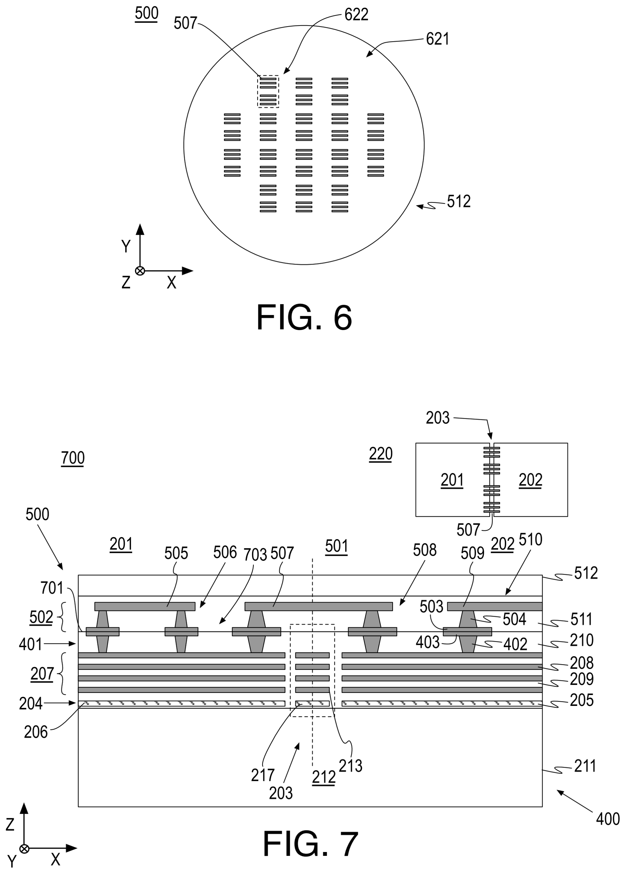

FIG. 6 is a plan view of example integrated circuit structure 500 showing a layout 621 of stitch interconnects 507 such that groups 622 of stitch interconnects 507 are provided to link adjacent ones of active regions 201, 202 (refer to FIG. 2). It is noted, some of stitch interconnects 507 may be used in a segmented die while others may be cut during segmentation from the wafer of carrier substrate 512. Although illustrated with all stitch interconnects 507 extending in the x-direction, stitch interconnects 507 may extend in any direction to couple neighboring active regions 201, 202. In some embodiments, each group 62 of stitch interconnects 507 is formed using a single exposure.

Returning to FIG. 1, processing continues at operation 104, where a carrier wafer is bonded to an integrated circuit wafer over the frontside interconnects, which are in turn over the device layer of the integrated circuit wafer. The carrier wafer is bonded to the integrated circuit wafer in preparation for removal of the substrate of the integrated circuit wafer and fabrication of backside interconnects. The carrier wafer provides mechanical support during such processing to provide the capability for both frontside and backside interconnects, which improves connection efficiency, power delivery, and so on. As discussed, in some embodiments, stitch interconnects are pre-fabricated in the carrier wafer prior to bonding. In such contexts, the carrier wafer may be hybrid bonded to the integrated circuit wafer such that they are aligned bond pad to bond pad and dielectric material to dielectric material. Such bonding may then occur when the carrier wafer and the integrated circuit wafer are brought together, and the bonding may be completed by an anneal operation, for example.

In other embodiments, stitch interconnects are formed after mounting the carrier wafer to the integrated circuit wafer. In such contexts, the carrier wafer may be mounted without a hybrid bond but instead a dielectric-to-dielectric bond or a substrate to dielectric bond. In either event, the substrate of the carrier wafer may be processed prior to or subsequent to backside interconnect formation to form the stitch interconnects. In the following description, hybrid bonding is discussed with respect to FIGS. 7, 8, and 13 and forming stitch interconnects after mounting to the carrier wafer is discussed with respect to FIG. 14. It is noted plan view FIGS. are pertinent to both process flows.

FIG. 7 illustrates a cross-sectional side view of an example integrated circuit structure 700 after bonding integrated circuit structure 500 to integrated circuit structure 200. As shown, at an interface 701, a hybrid bond is formed such that bond pads 503 bond with bond pads 403 and dielectric layer 210 bonds with dielectric layer 511. Such hybrid bonding may be performed using any suitable technique or techniques such as aligning integrated circuit structure 700 and integrated circuit structure 500, bringing them together to form an initial bond under van der Waal forces, and subsequent anneal processing. As shown in FIG. 7 and insert 220, stitch interconnects 507 span inactive region 203 and inactive metallization features 213 and inactive devices 217 therein to provide interconnection between active regions 201, 202.

Returning to FIG. 1, processing continues at operation 105, where backside interconnects are formed. Such backside interconnects may be formed in the presence of the metallization interconnect layers in the carrier wafer or such carrier wafer metallization interconnect layers may be fabricated subsequent to fabrication of the backside interconnects. The backside interconnects may be formed using suitable technique or techniques such substrate removal followed as dual damascene techniques, single damascene techniques, subtractive metallization patterning techniques, or the like. Notably, the device layer is between the frontside interconnects and the backside interconnects, and the metallization interconnect layers in the carrier wafer are over the frontside interconnects and interconnect active die regions.

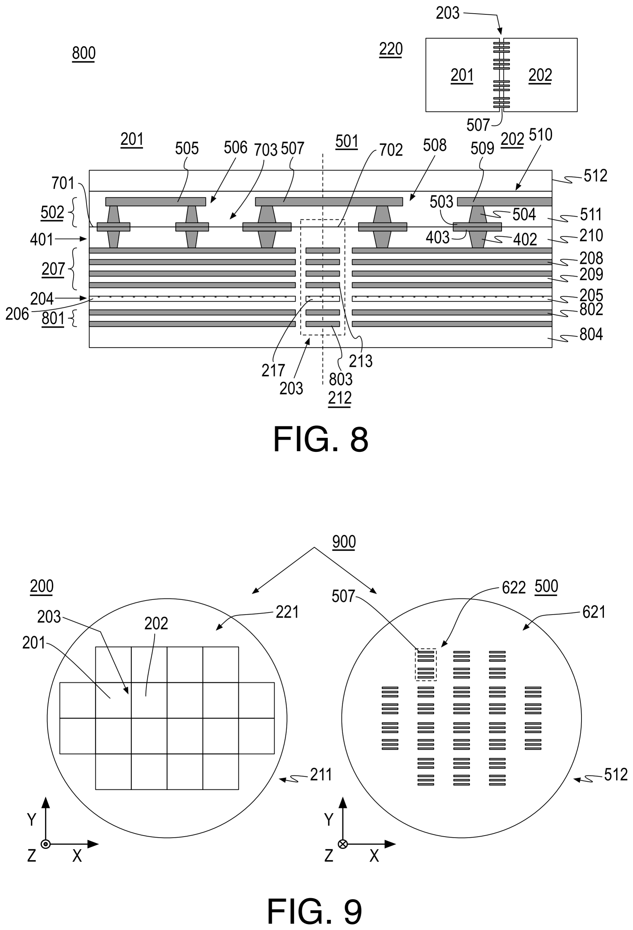

FIG. 8 illustrates a cross-sectional side view of an example integrated circuit structure 800 similar to integrated circuit structure 700 after removal of substrate 211 and fabrication of backside interconnect layers 801, which include interconnected metallization features 802 embedded in dielectric material 804. Interconnected metallization features 802 may include metal traces such as copper traces that interconnect particular devices of device layer 204 with layers of interconnected metallization features 802 vertically coupled by metal vias (not shown).

For example, interconnectivity, signal routing, power-delivery, and the like may be provided by frontside interconnect layers 207. Frontside interconnect layers 207 are formed over and immediately adjacent device layer 204. Frontside interconnect layers 207 may include any number of metallization layers such as six, eight, or more metallization layers. Similarly, backside interconnect layers 801, may be used for interconnectivity, signal routing, power-delivery, and any other suitable electrical connectivity. In some embodiments, frontside interconnect layers 207 are used exclusively for signal routing and backside interconnect layers 801 are used exclusively for power delivery. However, any interconnection architecture may be used. Backside interconnect layers 801 may include any number of metallization layers such as two, three, four, or more metallization layers.

As with frontside processing, each build-up layer of active region 201 may be formed, in part, using a single exposure and corresponding reticle with each build-up layer of active region 202 being formed, in part, using a separate exposure and the corresponding reticle. For example, inactive region 203 may further include portions of backside interconnect layers 801 with inactive metallization features 803 of backside interconnect layers 801 again not being part of the integrated circuit device. Inactive metallization features 803 may be test structures, measurement structures, or the like, and/or they may be deployed to provide topographic consistency. It is noted that some layers of frontside interconnect layers 207, device layer 204, and backside interconnect layers 801 may be absent any features within inactive region 203.

As shown, integrated circuit structure 800, and similar integrated circuit structures discussed herein, includes device layer 204 between frontside interconnect layers 207 and backside interconnect layers 801 such that each includes active regions 201, 202 and inactive region 203 between active regions 201, 202. Interface 701 includes interface region 702 over inactive region 203 with interface region 702 including dielectric layer 210 over frontside interconnect layers 207 and dielectric layer 511. Stitch interconnects 507 are over interface 701 and inactive region 203, and stitch interconnects 507 extend between and couple the active regions 201, 202 to provide die-to-die interconnectivity. Interface 701 further includes interface region 703 outside of inactive region 203 with interface region 703 including dielectric layer 210 bonded to dielectric layer 511 and bond pads 403 bonded to bond pads 503.

FIG. 9 is a plan view of example bonding 900 of integrated circuit structure 500 to integrated circuit structure 200. As shown, grid 221 of integrated circuit structure 200 may be aligned with layout 621 of groups 622 of integrated circuit structure 200 such that stitch interconnects 507 span over inactive regions 203 to interconnect active regions 201, 202. As discussed, active regions 201, 202 may be separate fields fabricated using separate reticle exposures.

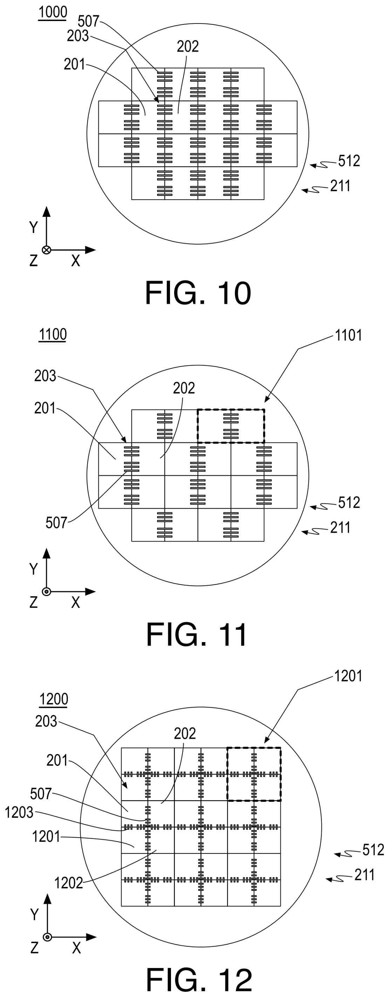

FIG. 10 is a plan view after bonding 900 and backside interconnect fabrication to form an integrated circuit structure 1000. Integrated circuit structure 1000 may have any features discussed with respect to integrated circuit structures 800, 1300, 1400, for example and is meant to illustrate exemplary routing of stitch interconnects 507. As discussed with respect to FIG. 9, stitch interconnects 507 span over inactive regions 203 to interconnect active regions 201, 202. In the context of FIG. 10, stitch interconnects 507 extend in the x-direction and interconnect each of active regions 201, 202. For example, some of stitch interconnects 507 may be cut during dicing. Furthermore, stitch interconnects 507 of FIG. 10 couple an inner edge of active region 201 to near an inner edge of active region 202. In other embodiments, stitch interconnects may extend into a central region of one or both of active regions 201, 202, to outer edges of one or both of active regions 201, 202, or even across multiple inactive regions 203. Furthermore, stitch interconnects 507 may extend in any dimensions, and stitch interconnects 507 may include jogs or other routing features.

FIG. 11 is a plan view after bonding 900 and backside interconnect fabrication to form an integrated circuit structure 1100 similar to integrated circuit structure 1000 with stitch interconnects 507 selectively applied to provide routing between two adjacent active regions 201, 202. Stitch interconnects 507 again span over inactive regions 203 to interconnect active regions 201, 202 with stitch interconnects 507 provided in a pattern to combine only adjacent ones of active regions 201, 202. In the context of FIG. 11, stitch interconnects 507 dicing or segmentation of integrated circuit structures such as integrated circuit structure 1101 may be removed without severing stitch interconnects 507. For example, a shot map or patterning map may be deployed to limit stitch interconnects 507 that are not needed for active routing. Active stitch interconnects 507 may couple any number of active regions 201, 202 such as two, four, six, or more.

FIG. 12 is a plan view after bonding 900 and backside interconnect fabrication to form an integrated circuit structure 1200 similar to integrated circuit structure 1000 with stitch interconnects 507 selectively applied to provide routing between four adjacent active regions 201, 202, 1201, 1202. Active regions 1201, 1202 may have any characteristics discussed with respect to active regions 201, 202.Stitch interconnects 507 again span over inactive regions 203 to interconnect active regions 201, 202 with stitch interconnects 507 in FIG. 12 spanning over inactive regions 203 in the x-direction and in the orthogonal y-direction. In such examples, stitch interconnects 507 may combine four active regions 201, 202 for dicing or segmentation into an integrated circuit structure 1201 as discussed with respect to FIG. 11.

FIG. 13 illustrates a cross-sectional side view of an example integrated circuit structure 1300 similar to integrated circuit structure 800 (see FIG. 8) and like numerals an components may have any of the characteristics discussed above. In the context of FIG. 13, integrated circuit structure 1300 includes a multi-level metallization interconnect layers 1301 including interconnects 505, 507, 509, metal vias 504, bond pads 503, and additional interconnects 1302, 1303, 1304 coupled to interconnects 505, 507, 509 by metal vias 1305. Interconnects 1302, 1303, 1304 and metal vias 1305 may be formed using any suitable technique or techniques discussed above. For example, metallization interconnect layers 1301 may include any number of layers of interconnects 1302, 1303, 1304 to provide routing flexibility for integrated circuit structure 1300.

Returning to FIG. 1, processing continues at operation 106, where the carrier wafer may be thinned or removed using any suitable technique or techniques such as grind techniques or the like. For example, the carrier wafer may be thinned or removed prior to segmentation processing at operation 108.

Discussion now turns to embodiments where stitch interconnects are formed after carrier wafer mounting. It is noted such pre- and post-carrier wafer attach interconnect fabrication techniques may be deployed in any suitable processing context

Returning to FIG. 1, processing continues at operation 107, a carrier wafer absent pre-fabricated stitch interconnects may be thinned, through substrate vias may be formed, and the stitch interconnect routing may be fabricated. The substrate carrier wafer may be thinned using any suitable technique or techniques such as grind techniques or the like. Through substrate vias (e.g., through silicon vias) may then be formed to contact the frontside metallization within the active regions. The through substrate vias may be formed using any suitable technique or techniques such as applying a patterned layer having openings for the vias, etching the substrate, removing the patterned layer, and filling the openings. Any number of layers of stitch interconnects and any metal vias may then be formed by, for example, deposition of a dielectric layer, patterning a resist layer over the dielectric layer, etching the dielectric layer, and metal fill.

FIG. 14 illustrates a cross-sectional side view of an example integrated circuit structure 1400 similar to integrated circuit structure 200 after attachment of carrier substrate 512, optional thinning of carrier substrate 512, fabrication of through substrate vias 1402, and formation of metallization interconnect layers 502. As discussed, carrier substrate 512 may be mounted and thinned using any suitable technique or techniques. Dielectric layer 1412, interconnects 505, 507, 509, interconnects 1302, 1303, 1304, and metal vias 1403 may then be fabricated using any suitable technique or techniques. In some embodiments, one or more layers of dielectric layer 1412 are deposited and optionally planarized, and some of interconnects 505, 507, 509, interconnects 1302, 1303, 1304, and metal vias 1403 are formed as discussed herein using, for example, damascene or dual damascene techniques, which may be repeated as needed. Metallization interconnect layers 502 may include any number of layers such as two (as illustrated) or more, or even a single layer inclusive of interconnects 505, 507, 509.

Integrated circuit structure 1400 may have any suitable plan view layout as discussed herein. As shown, integrated circuit structure 1400, and similar integrated circuit structures, includes device layer 204 between frontside interconnect layers 207 and backside interconnect layers 801 such that each includes active regions 201, 202 and inactive region 203 between active regions 201, 202. Interface 701 includes interface region 702 over inactive region 203 with interface region 702 including dielectric layer 210 over frontside interconnect layers 207 and carrier substrate 512. Stitch interconnects 507 are over interface 701 and inactive region 203, and stitch interconnects 507 extend between and couple the active regions 201, 202 to provide die-to-die interconnectivity as discussed herein. Interface 701 further includes interface region 703 outside of inactive region 203 with interface region 703 including dielectric layer 210 bonded to carrier substrate 512 with through substrate vias 1402 extending through interface 701 in interface region 703.

Returning to FIG. **1****,** processing continues at operation 108, where integrated circuit structures including multiple active regions are diced or segmented for inclusion in a packaged product. As discussed, each integrated circuit structure may include any number (e.g., two or four) of active regions interconnect by carrier-wafer level stitch interconnects. Processing continues at operation 109, where the resultant device (e.g., IC structure) may be packaged, assembled, implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

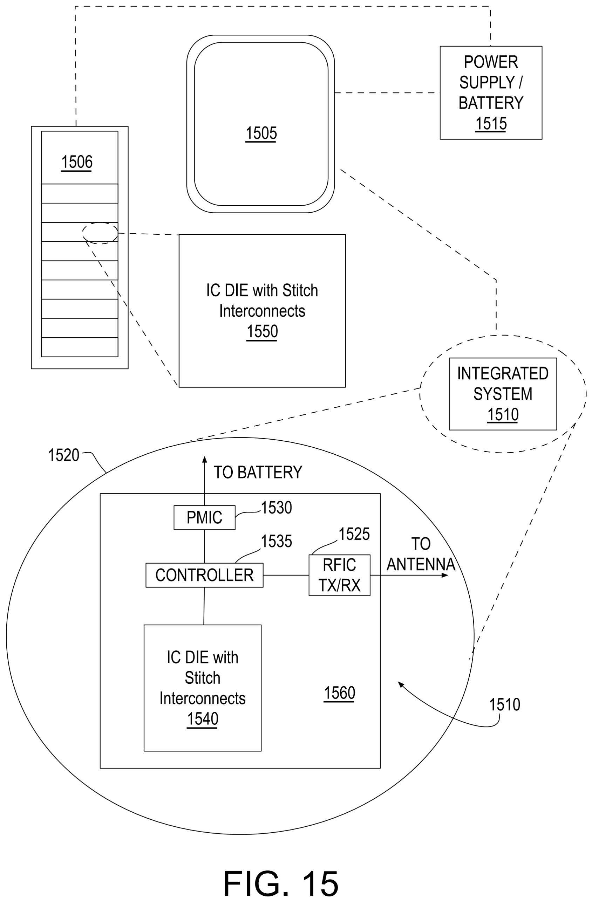

FIG. 15 illustrates exemplary systems employing integrated circuit structures with carrier-wafer based die-to-die stitching, arranged in accordance with at least some implementations of the present disclosure. The system may be a mobile computing platform 1505 and/or a data server machine 1506, for example. Either may employ integrated circuit structures with carrier-wafer based die-to-die stitching as described elsewhere herein. Server machine 1506 may be any commercial server, for example including any number of high-performance computing platforms disposed within a rack and networked together for electronic data processing, which in the exemplary embodiment includes an IC die assembly 1550 with an IC die employing integrated circuit structures with carrier-wafer based die-to-die stitching as described elsewhere herein. Mobile computing platform 1505 may be any portable device configured for each of electronic data display, electronic data processing, wireless electronic data transmission, or the like. For example, mobile computing platform 1505 may be any of a tablet, a smart phone, a laptop computer, etc., and may include a display screen (e.g., a capacitive, inductive, resistive, or optical touchscreen), a chip-level or package-level integrated system 1510, and a battery 1515. Although illustrated with respect to mobile computing platform 1505, in other examples, chip-level or package-level integrated system 1510 and a battery 1515 may be implemented in a desktop computing platform, an automotive computing platform, an internet of things platform, or the like. As discussed below, in some examples, the disclosed systems may include a sub-system 1560 such as a system on a chip (SOC) or an integrated system of multiple ICs, which is illustrated with respect to mobile computing platform 1505.

Whether disposed within integrated system 1510 illustrated in expanded view 1520 or as a stand-alone packaged device within data server machine 1506, sub-system 1560 may include memory circuitry and/or processor circuitry 1540 (e.g., RAM, a microprocessor, a multi-core microprocessor, graphics processor, etc.), a power management integrated circuit (PMIC) 1530, a controller 1535, and a radio frequency integrated circuit (RFIC) 1525 (e.g., including a wideband RF transmitter and/or receiver (TX/RX)). As shown, one or more IC dies, such as memory circuitry and/or processor circuitry 1540 may be fabricated and implemented such that one or more have integrated circuit structures with carrier-wafer based die-to-die stitching as described herein. In some embodiments, RFIC 1525 includes a digital baseband and an analog front-end module further comprising a power amplifier on a transmit path and a low noise amplifier on a receive path). Functionally, PMIC 1530 may perform battery power regulation, DC-to-DC conversion, etc., and so has an input coupled to battery 1515, and an output providing a current supply to other functional modules. As further illustrated in FIG. 15, in the exemplary embodiment, RFIC 1525 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1540 may provide memory functionality for sub-system 1560, high level control, data processing and the like for sub-system 1560. In alternative implementations, each of the SOC modules may be integrated onto separate ICs coupled to a package substrate, interposer, or board.

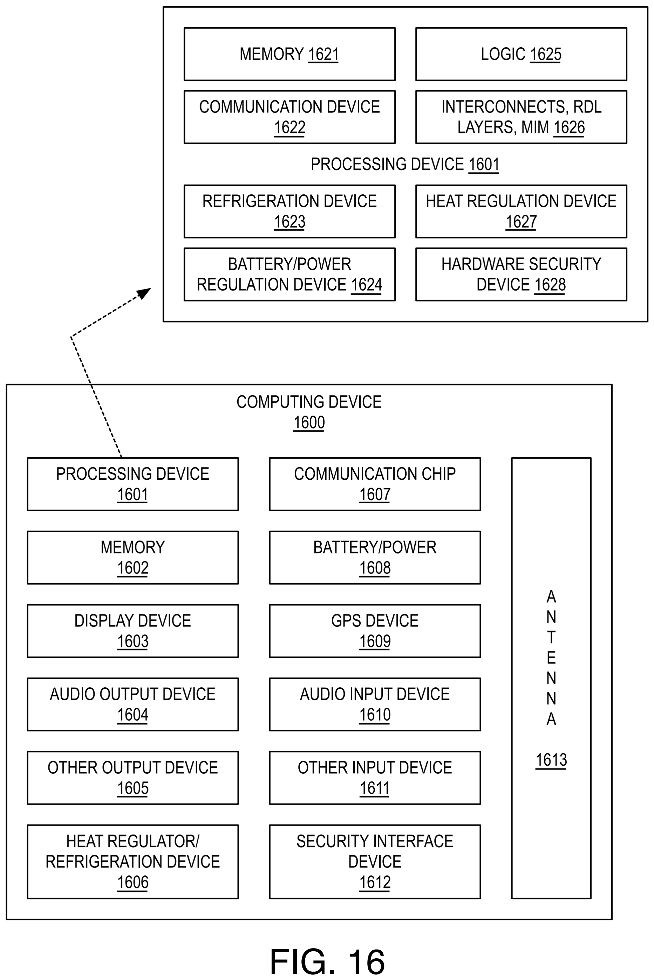

FIG. 16 is a block diagram of a computing device 1600, arranged in accordance with at least some implementations of the present disclosure. For example, one or more components of computing device 1600 may include any of the integrated circuit structures with carrier-wafer based die-to-die stitching as discussed elsewhere herein. A number of components are illustrated in FIG. 16, but any one or more of these components may be omitted or duplicated, as suitable for the application. In some embodiments, some of the components included in computing device 1600 may be attached to one or more printed circuit boards (e.g., a motherboard). In some embodiments, various ones of these components may be fabricated onto a single system-on-a-chip (SoC) die or implemented with a disintegrated plurality of chiplets or tiles packaged together. Any of such packaged components may include integrated circuit structures with carrier-wafer based die-to-die stitching as discussed herein. Additionally, in various embodiments, computing device 1600 may not include one or more of the components illustrated in FIG. 16, but computing device 1600 may include interface circuitry for coupling to the one or more components. For example, computing device 1600 may not include a display device 1603, but may include display device interface circuitry (e.g., a connector and driver circuitry) to which display device 1603 may be coupled.

Computing device 1600 may include a processing device 1601 (e.g., one or more processing devices). As used herein, the term processing device or processor indicates a device that processes electronic data from registers and/or memory to transform that electronic data into other electronic data that may be stored in registers and/or memory. Processing device 1601 may include a memory 1621, a communication device 1622, a refrigeration/active cooling device 1623, a battery/power regulation device 1624, logic 1625, interconnects 1626, a heat regulation device 1627, and a hardware security device 1628.

Processing device 1601 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable compute units.

Processing device 1601 may include a memory 1602, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing device 1601 shares a package with memory 1602. This memory may be used as cache memory and may include embedded dynamic random-access memory (eDRAM) or spin transfer torque magnetic random-access memory (STT-M RAM).

Computing device 1600 may include a heat regulation/refrigeration device 1606. Heat regulation/refrigeration device 1606 may maintain processing device 1601 (and/or other components of computing device 1600) at a predetermined low temperature during operation. This predetermined low temperature may be any temperature discussed elsewhere herein.

In some embodiments, computing device 1600 may include a communication chip 1607 (e.g., one or more communication chips). For example, the communication chip 1607 may be configured for managing wireless communications for the transfer of data to and from computing device 1600. The term "wireless" and its derivatives may be used to describe circuits, devices, systems, methods, techniques, communications channels, etc., that may communicate data through the use of modulated electromagnetic radiation through a nonsolid medium.

Computing device 1600 may include any photonics structure discussed herein that may facilitate communication between one or more instances of processing device 1601 and/or one or more instances of memory 1602, for example.

Computing device 1600 may include battery/power circuitry 1608. Battery/power circuitry 1608 may include one or more energy storage devices (e.g., batteries or capacitors) and/or circuitry for coupling components of computing device 1600 to an energy source separate from computing device 1600 (e.g., AC line power).

Computing device 1600 may include a display device 1603 (or corresponding interface circuitry, as discussed above). Display device 1603 may include any visual indicators, such as a heads-up display, a computer monitor, a projector, a touchscreen display, a liquid crystal display (LCD), a light-emitting diode display, or a flat panel display, for example.

Computing device 1600 may include an audio output device 1604 (or corresponding interface circuitry, as discussed above). Audio output device 1604 may include any device that generates an audible indicator, such as speakers, headsets, or earbuds, for example.

Computing device 1600 may include an audio input device 1610 (or corresponding interface circuitry, as discussed above). Audio input device 1610 may include any device that generates a signal representative of a sound, such as microphones, microphone arrays, or digital instruments (e.g., instruments having a musical instrument digital interface (MIDI) output).

Computing device 1600 may include a global positioning system (GPS) device 1609 (or corresponding interface circuitry, as discussed above). GPS device 1609 may be in communication with a satellite-based system and may receive a location of computing device 1600, as known in the art.

Computing device 1600 may include another output device 1605 (or corresponding interface circuitry, as discussed above). Examples include an audio codec, a video codec, a printer, a wired or wireless transmitter for providing information to other devices, or an additional storage device.

Computing device 1600 may include another input device 1611 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1600 may include a security interface device 1612. Security interface device 1612 may include any device that provides security measures for computing device 1600 such as intrusion detection, biometric validation, security encode or decode, managing access lists, malware detection, or spyware detection.

Computing device 1600 may include an antenna 1613. Antenna 1613 may include any device that translates electrical current to radio waves and/or translates radio waves to electrical current.

Computing device 1600, or a subset of its components, may have any appropriate form factor, such as a server or other networked computing component, a mobile device, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

The following pertain to exemplary embodiments.

In one or more first embodiments, an apparatus comprises a device layer between first interconnect layers and second interconnect layers, the device layer, the first interconnect layers, and the second interconnect layers each comprising a first active region, a second active region, and an inactive region therebetween, an interface comprising an interface region over the inactive region, the interface region comprising a first dielectric layer over the first interconnect layers and one of a second dielectric layer or a substrate layer, and one or more third interconnects over the interface and the inactive region and extending between and coupling the first active region and the second active region.

In one or more second embodiments, further to the first embodiments, the interface region or a second interface region of the interface comprises a first bond pad over the first interconnect layers bonded to a second bond pad over the second interconnect layers.

In one or more third embodiments, further to the first or second embodiments, the one or more third interconnects are in a first interconnect level, the apparatus further comprising one or more fourth interconnects in a second interconnect level, wherein the one or more third interconnects are between the first interconnect layers and the one or more fourth interconnects.

In one or more fourth embodiments, further to the first through third embodiments, the interface region comprises the first dielectric layer and the substrate layer, the apparatus further comprising a through substrate via extending through the substrate layer and in contact with a first of the one or more third interconnects and the first interconnect layers in the first active region.

In one or more fifth embodiments, further to the first through fourth embodiments, the one or more third interconnects are in a first interconnect level, the apparatus further comprising one or more fourth interconnects in the first interconnect level, coupled to the first interconnect layers and confined within the first active region.

In one or more sixth embodiments, further to the first through fifth embodiments, the device layer, the first interconnect layers, and the second interconnect layers each comprise a third active region and a second inactive region between the first active region and the third active region, the apparatus further comprising one or more fourth interconnects extending between and coupling the first active region and the third active region, the one or more fourth interconnects extending orthogonal to the one or more third interconnects.

In one or more seventh embodiments, further to the first through sixth embodiments, the first active region is defined by a first reticle field, the second active region is defined by a second reticle field, and the one or more third interconnects are defined by a third reticle field.

In one or more eighth embodiments, further to the first through seventh embodiments, the apparatus further comprises a power supply, and an integrated circuit device coupled to the power supply, the integrated circuit device comprising the device layer, the first interconnect layers, the second interconnect layers, the interface, and the one or more third interconnects.

In one or more ninth embodiments, further to the first through eighth embodiments, a system comprises an IC die according to any of the apparatuses of the first through seventh embodiments, and a power supply and/or display coupled to the IC die.

In one or more tenth embodiments, an apparatus comprises a device layer between frontside interconnect layer and a backside interconnect layer, the device layer, the frontside interconnect layer, and the backside interconnect layer each comprising a first active region, a second active region, and an inactive region therebetween, a bonding interface over the first active region, the second active region, and the inactive region, the bonding interface comprising a first dielectric layer over the frontside interconnect layer and one of a second dielectric layer or a substrate layer, and stitch interconnects over the inactive region and extending between and coupling the frontside interconnect layer in the first active region to the frontside interconnect layer in the second active region.

In one or more eleventh embodiments, further to the tenth embodiments, the bonding interface comprises a hybrid bond, the hybrid bond comprising a first bond between the first dielectric layer and the second dielectric layer and a second bond between a first bond pad and a second bond pad.

In one or more twelfth embodiments, further to the tenth or eleventh embodiments, the stitch interconnects comprise a first interconnect level adjacent the frontside interconnect layer and a second interconnect level opposite the first interconnect level from the frontside interconnect layer.

In one or more thirteenth embodiments, further to the tenth through twelfth embodiments, the bonding interface comprises the first dielectric layer and the substrate layer, the apparatus further comprising a through substrate via extending through the substrate layer and in contact with the stitch interconnects and the frontside interconnect layer in the first active region.

In one or more fourteenth embodiments, further to the tenth through thirteenth embodiments, the stitch interconnects are in a first interconnect level, the first interconnect level further comprising a plurality of intra active region interconnects in the first interconnect level.

In one or more fifteenth embodiments, further to the tenth through fourteenth embodiments, the device layer, the frontside interconnect layer, and the backside interconnect layer each comprise a third active region and a second inactive region between the first active region and the third active region, the apparatus further comprising second stitch interconnects extending between and coupling the first active region and the third active region, the second stitch interconnects extending orthogonal to the stitch interconnects.

In one or more sixteenth embodiments, further to the tenth through fifteenth embodiments, the apparatus further comprises a power supply, and an integrated circuit device coupled to the power supply, the integrated circuit device comprising the device layer, the frontside interconnect layer, the backside interconnect layer, the bonding interface, and the stitch interconnects.

In one or more seventeenth embodiments, a system comprises an IC die according to any of the apparatuses of the tenth through fifteenth embodiments, and a power supply and/or display coupled to the IC die.

In one or more eighteenth embodiments, a method comprises forming first interconnect layers over a device layer, the device layer over a first substrate, wherein the device layer and the first interconnect layers each comprise a first active region, a second active region, and an inactive region therebetween, the first active regions and the second active regions formed using separate reticle exposures, bonding a second substrate to the first substrate and over the first interconnect layers, wherein the second substrate comprises one or more second interconnects formed prior to bonding or subsequent to bonding, the second interconnects extending between and coupling the first active region and the second active region, and forming third interconnect layers opposite the device layer from the first interconnect layers while the first substrate is bonded to the second substrate.

In one or more nineteenth embodiments, further to the eighteenth embodiments, the method further comprises forming, prior to said bonding, the second interconnects over the second substrate, wherein said bonding the second substrate to the first substrate comprises hybrid bonding first bond pads of the first substrate to second bond pads of the second substrate and a first dielectric material of the first substrate to a second dielectric material of the second substrate.

In one or more twentieth embodiments, further to the eighteenth or nineteenth embodiments, the second interconnects are in a first interconnect level, and the method further comprises forming, prior to said bonding, fourth interconnects over the second interconnects.

In one or more twenty-first embodiments, further to the eighteenth through twentieth embodiments, the method further comprises removing, subsequent to said forming the third interconnect layers, at least a portion of the second substrate.

In one or more twenty-second embodiments, further to the eighteenth through twenty-first embodiments, the method further comprises forming, subsequent to said bonding, the second interconnects over the second substrate, wherein said forming the second interconnects comprises forming through substrate vias extending through the second substrate.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a device layer between first interconnect layers and second interconnect layers, the device layer, the first interconnect layers, and the second interconnect layers each comprising a first active region, a second active region, and an inactive region therebetween;
an interface comprising an interface region over the inactive region, the interface region comprising a first dielectric layer over the first interconnect layers and one of a second dielectric layer or a substrate layer; and
one or more third interconnects over the interface and the inactive region and extending between and coupling the first active region and the second active region.

2. The apparatus of claim 1, wherein the interface region or a second interface region of the interface comprises a first bond pad over the first interconnect layers bonded to a second bond pad over the second interconnect layers.

3. The apparatus of claim 1 or 2, wherein the one or more third interconnects are in a first interconnect level, the apparatus further comprising one or more fourth interconnects in a second interconnect level, wherein the one or more third interconnects are between the first interconnect layers and the one or more fourth interconnects.

4. The apparatus of any of claims 1 to 3, wherein the interface region comprises the first dielectric layer and the substrate layer.

5. The apparatus of claim 4, further comprising a through substrate via extending through the substrate layer and in contact with a first of the one or more third interconnects and the first interconnect layers in the first active region.

6. The apparatus of claim 1 or 2, wherein the one or more third interconnects are in a first interconnect level, the apparatus further comprising one or more fourth interconnects in the first interconnect level, coupled to the first interconnect layers and confined within the first active region.

7. The apparatus of any of claims 1 to 6, wherein the device layer, the first interconnect layers, and the second interconnect layers each comprise a third active region and a second inactive region between the first active region and the third active region.

8. The apparatus of claim 7, further comprising one or more fourth interconnects extending between and coupling the first active region and the third active region, the one or more fourth interconnects extending orthogonal to the one or more third interconnects.

9. The apparatus of any of claims 1 to 8, wherein the first active region is defined by a first reticle field, the second active region is defined by a second reticle field, and the one or more third interconnects are defined by a third reticle field.

10. The apparatus of any of claims 1 to 10, further comprising:
a power supply; and
an integrated circuit device coupled to the power supply, the integrated circuit device comprising the device layer, the first interconnect layers, the second interconnect layers, the interface, and the one or more third interconnects.

11. A method, comprising:
forming first interconnect layers over a device layer, the device layer over a first substrate, wherein the device layer and the first interconnect layers each comprise a first active region, a second active region, and an inactive region therebetween, the first active regions and the second active regions formed using separate reticle exposures;
bonding a second substrate to the first substrate and over the first interconnect layers, wherein the second substrate comprises one or more second interconnects formed prior to bonding or subsequent to bonding, the second interconnects extending between and coupling the first active region and the second active region; and
forming third interconnect layers opposite the device layer from the first interconnect layers while the first substrate is bonded to the second substrate.

12. The method of claim 11, further comprising:
forming, prior to said bonding, the second interconnects over the second substrate, wherein said bonding the second substrate to the first substrate comprises hybrid bonding first bond pads of the first substrate to second bond pads of the second substrate and a first dielectric material of the first substrate to a second dielectric material of the second substrate.

13. The method of claim 12, wherein the second interconnects are in a first interconnect level, the method further comprising:
forming, prior to said bonding, fourth interconnects over the second interconnects.

14. The method of any of claims 11 to 13, further comprising:
removing, subsequent to said forming the third interconnect layers, at least a portion of the second substrate.

15. The method of any of claims 11 to 14, further comprising:
forming, subsequent to said bonding, the second interconnects over the second substrate, wherein said forming the second interconnects comprises forming through substrate vias extending through the second substrate.
